# EUROPÄISCHE PATENTSCHRIFT

(11) **EP 4 202 375 B1**
(45) Veröffentlichungstag und Bekanntmachung des Hinweises auf die Patenterteilung: **24.07.2024**
(21) Anmeldenummer: 22214617.7
(22) Anmeldetag: 19.12.2022
(51) Int. Cl.: G01D 21/00, G01J 1/44, G01T 1/17, G01D 5/248

(54) **MESSGERÄT**
MEASURING DEVICE
APPAREIL DE MESURE

(30) Priorität: 27.12.2021 DE 102021215052
(43) Veröffentlichungstag der Anmeldung: 28.06.2023
(73) Patentinhaber: BERTHOLD TECHNOLOGIES GmbH & Co. KG, 75323 Bad Wildbad (DE)
(72) Erfinder: Bonath, Martin, 76131 Karlsruhe (DE); Greim, Roman, 76133 Karlsruhe (DE); Nagy, Ferdinand, 75305 Neuenbürg-Arnbach (DE)
(74) Vertreter: Patentanwälte Ruff, Wilhelm, Beier, Dauster & Partner mbB

(56) Entgegenhaltungen:
- EP-A1- 3 842 838
- EP-A2- 2 852 154
- WO-A1-2018/046454
- DD-A1- 119 940
- US-A1- 2021 033 648

## Beschreibung

Die Erfindung betrifft ein Messgerät zum Ermitteln einer Messgröße, das einen möglichst gro-ßen Dynamikbereich aufweist.

Das Messgerät dient herkömmlich zum Ermitteln mindestens einer Messgröße.

Das Messgerät weist einen herkömmlichen Sensor bzw. Detektor auf, der zur Erzeugung eines von der Messgröße abhängigen Messstroms dient. Zwischen Messstrom und Messgröße liegt typisch ein bekannter Zusammenhang vor, beispielsweise ein linearer Zusammenhang, etc. Insoweit sei auch auf die einschlägige Fachliteratur verwiesen.

Das Messgerät weist weiter einen Strom/Frequenz-Wandler auf, der dazu ausgebildet ist, ein, insbesondere rechteckförmiges, Messsignal zu erzeugen, dessen Frequenz von der Stromstärke des Messstroms abhängt. Zwischen Frequenz und Stromstärke des Messstroms liegt hierbei ein bekannter Zusammenhang vor, beispielsweise ein linearer Zusammenhang, etc. Insoweit sei auch auf die einschlägige Fachliteratur verwiesen.

Der Strom/Frequenz-Wandler weist einen Integrationskondensator auf, der während eines Ladezyklus mit dem Messstrom geladen wird.

Der Strom/Frequenz-Wandler weist weiter eine Entladeschaltung auf, die dazu ausgebildet ist, den Integrationskondensator während eines Entladezyklus zu entladen, sobald ein Betrag einer an dem Integrationskondensator auftretenden Spannung einen vorgegebenen Schwellenwert überschreitet.

Die Frequenz des Messsignals entspricht der Frequenz, mit der sich Ladezyklen und Entladezyklen abwechseln.

Das Messgerät weist weiter eine Auswerteeinheit auf, die dazu ausgebildet ist, basierend auf der Frequenz des Messsignals die Messgröße zu ermitteln.

Die oben genannten Komponenten sind hinlänglich bekannt, daher sei insoweit auch auf die einschlägige Fachliteratur verwiesen. Aus der WO 2018/046454 A1 ist beispielsweise ein Strahlungsdetektor bekannt.

Erfindungsgemäß weist die Entladeschaltung ein Relais bzw. ein elektromechanisches Schaltelement und ein Halbleiterschaltmittel auf, beispielsweise in Form eines Feldeffekttransistors, insbesondere eines JFET, wobei das Relais und das Halbleiterschaltmittel in Reihe geschaltet sind und die Reihenschaltung aus Relais und Halbleiterschaltmittel dem Integrationskondensator parallel geschaltet ist. Die Entladeschaltung weist weiter eine Steuereinrichtung auf, die dazu ausgebildet ist, das Relais und das Halbleiterschaltmittel in Abhängigkeit von der Stromstärke des Messstroms anzusteuern.

In einer Ausführungsform ist die Steuereinrichtung dazu ausgebildet, während des Ladezyklus das Relais derart anzusteuern, dass das Relais bzw. dessen Schaltkontakte geöffnet ist/sind, falls ein Betrag einer Stromstärke des Messstroms einen vorgegebenen Schwellenwert unterschreitet, um Leckströme durch die Reihenschaltung aus Relais und Halbleiterschaltmittel zuverlässig zu unterdrücken, selbst wenn das Halbleiterschaltmittel einen vergleichsweise geringen Isolationswiderstand aufweist. Falls der Betrag der Stromstärke des Messstroms den/einen vorgegebenen Schwellenwert überschreitet, ist die Steuereinrichtung dazu ausgebildet, während des Ladezyklus das Relais derart anzusteuern, dass das Relais dauerhaft geschlossen ist/bleibt, und das Halbleiterschaltmittel derart anzusteuern, dass dieses geöffnet ist.

In einer Ausführungsform ist die Steuereinrichtung dazu ausgebildet, während des Entladezyklus das Relais und das Halbleiterschaltmittel für eine Mindestzeitdauer gleichzeitig zu schließen. Ab einem bestimmten Betrag der Stromstärke des Messstroms kann das Relais dauerhaft geschlossen bleiben.

In einer Ausführungsform ist das Relais ein Reed-Relais.

In einer Ausführungsform ist der Sensor bzw. Detektor ein Photomultiplier, oder ein Zählrohr, oder eine Ionisationskammer.

In einer Ausführungsform weist der Strom/Frequenz-Wandler einen Operationsverstärker auf, wobei der Integrationskondensator und der Operationsverstärker herkömmlich derart verschaltet sind, dass diese einen Integrierer zum Integrieren des Messstroms bilden.

In einer Ausführungsform ist die Messgröße eine Eigenschaft ionisierender Strahlung oder eine daraus abgeleitete Größe, beispielsweise eine Strahlungsdosis, eine Strahlungsdosisleistung, etc.

Bei der Verwendung von Sensoren in Form von Photomultipliern kann die Messgröße alternativ auch Eigenschaften wie das Vorhandensein, die Anzahl, die Rate, usw. von Fluoreszenz- oder Phosphoreszenz-Photonen abbilden. In anderen Fällen kann die Messgröße auch Eigenschaften von Szintillationsphotonen aufgrund von ionisierender Strahlung betreffen, die mit Photomultipliern gemessen werden.

In Strom/Frequenz-Wandlern kommen derzeit üblicherweise Schalter auf Halbleiterbasis zum Einsatz. Die besten erhältlichen Schalter (spezielle JFETs) weisen Leckströme über die Spannungsversorgung oder über die zu schaltenden Kontakte im Bereich von 100 fA bei Raumtemperatur auf. Bei höheren Temperaturen steigen die Leckströme exponentiell an. Darüber hinaus sind für akzeptable Isolationswiderstände etwas höhere Betriebsspannungen nötig. Auf der anderen Seite haben elektromechanische Schalter (beispielsweise Reed-Relais) mit extrem hohen Isolationswiderständen (> 10 TΩ) nur sehr begrenzte Schaltfrequenzen bis maximal 500 Hz. Der Messbereich ist daher auf wenige Dekaden beschränkt. Die Erfindung überwindet die Schwächen beider Schaltelemente in diesem Einsatzbereich.

Durch die erfindungsgemäße Kombination von elektronischen und elektromechanischen Schaltelementen verbunden mit deren erfindungsgemäßer Ansteuerung, können die Vorteile beider Schaltelemente miteinander verbunden werden: hohe Schaltfrequenz eines Halbleiterschaltmittels und niedrigste Leckströme eines entsprechenden Relais. Dies ermöglicht es, ohne Bereichsumschaltung den Messbereich um mehrere Dekaden zu erweitern. Bei kleinen Strömen sorgt ein geöffnetes Relais für einen hohen Isolationswiderstand zum sensitiven Eingang der Schaltung. Bei hohen Strömen kann das Relais dauerhaft geschlossen bleiben, da hier der Isolationswiderstand des Halbleiterschaltmittels ausreichend ist. Die Leckströme sind in diesem Fall gegenüber dem Messstrom vernachlässigbar. Das Halbleiterschaltmittel übernimmt dann die Rolle als Lade-/Entladeschalter allein.

Die Erfindung wird nachfolgend unter Bezugnahme auf die Zeichnungen detailliert beschrieben. Hierbei zeigt:
- Fig. 1: schematisch ein Blockschaltbild eines Messgeräts mit einem Sensor, einem Strom/Frequenz-Wandler und einer Auswerteeinheit,
- Fig. 2: schematisch ein Schaltbild des Strom/Frequenz-Wandlers und
- Fig. 3: schematisch ein Schaltbild einer Steuereinheit des Strom/Frequenz-Wandlers.

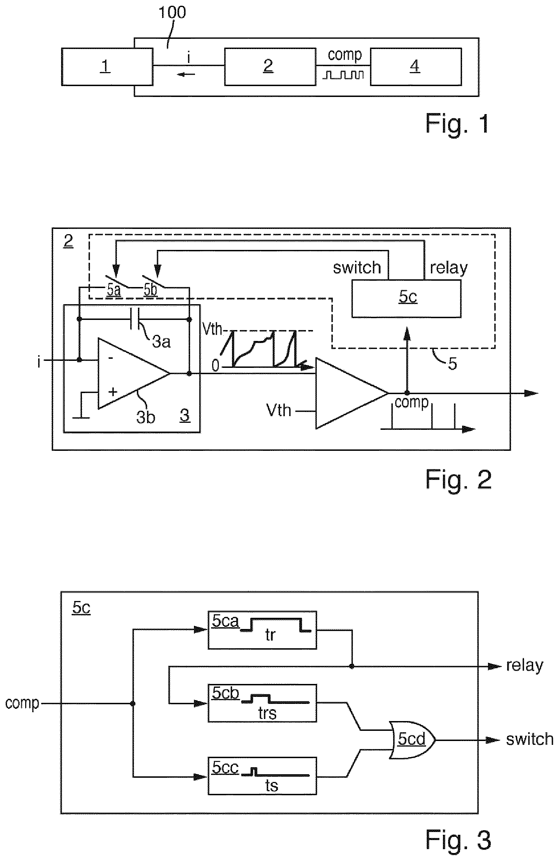

Fig. 1 zeigt ein Messgerät 100 zum Ermitteln einer Messgröße in Form einer Strahlungsdosis oder Strahlungsdosisleistung, aufweisend einen Sensor oder Detektor 1 in Form einer Ionisationskammer oder eines Zählrohrs oder eines Photomultipliers zur Erzeugung eines von der Messgröße abhängigen Messstroms i, einen Strom/Frequenz-Wandler 2, der dazu ausgebildet ist, ein rechteckförmiges Messsignal comp zu erzeugen, dessen Frequenz von der Stromstärke des Messstroms i abhängt, und eine Auswerteeinheit 4, die dazu ausgebildet ist, basierend auf der Frequenz des Messsignals comp die Messgröße zu ermitteln.

Fig. 2 zeigt schematisch ein Schaltbild des Strom/Frequenz-Wandlers 2 aus Fig. 1.

Der Strom/Frequenz-Wandler 2 weist einen Integrationskondensator 3a und einen Operationsverstärker 3b in der dargestellten Beschaltung auf, wobei der Integrationskondensator 3a und der Operationsverstärker 3b derart verschaltet sind, dass diese einen Integrierer 3 zum Integrieren des Messstroms i bilden. Der Integrationskondensator 3a wird während eines Ladezyklus mit dem Messstrom i geladen und während eines Entladezyklus wieder entladen. Eine Frequenz des Messsignals comp entspricht der Frequenz, mit der sich Ladezyklen und Entladezyklen abwechseln.

Der Strom/Frequenz-Wandler 2 weist eine Entladeschaltung 5 auf, die dazu ausgebildet ist, den Integrationskondensator 3a während des Entladezyklus zu entladen, sobald ein Betrag einer an dem Integrationskondensator 3a auftretende Spannung einen vorgegebenen Schwellenwert Vth überschreitet. Die Entladeschaltung 5 weist ein Reed-Relais 5a und ein Halbleiterschaltmittel 5b auf, beispielsweise in Form eines FET, wobei das Relais 5a und das Halbleiterschaltmittel 5b in Reihe geschaltet sind und die Reihenschaltung aus Relais 5a und Halbleiterschaltmittel 5b dem Integrationskondensator 3a parallel geschaltet ist.

Die Entladeschaltung 5 weist weiter eine Steuereinrichtung 5c auf, die dazu ausgebildet ist, das Relais 5a mittels des Steuersignals "relay" und das Halbleiterschaltmittel 5b mittels des Steuersignals "switch" in Abhängigkeit von der Stromstärke des Messstroms i anzusteuern, was nachfolgend unter Bezugnahme auf Fig. 3 detailliert beschrieben werden wird.

Die Steuereinrichtung 5c ist dazu ausgebildet, falls ein Betrag einer Stromstärke des Messstroms i einen vorgegebenen Schwellenwert unterschreitet, während des Ladezyklus das Relais 5a derart anzusteuern, dass das Relais 5a geöffnet ist, und falls der Betrag der Stromstärke des Messstroms i den vorgegebenen Schwellenwert überschreitet, während des Ladezyklus das Relais 5a derart anzusteuern, dass das Relais 5a geschlossen ist. Die Steuereinrichtung 5c ist dazu ausgebildet, während des Entladezyklus das Relais 5a und das Halbleiterschaltmittel 5b für eine Mindestzeitdauer gleichzeitig zu schließen.

Der vorgegebene Schwellenwert ist hierbei deutlich größer gewählt als jeder Leckstrom, der über das Halbleiterschaltmittel 5b fließen könnte. Bei hohen Temperaturen können Leckströme über das Halbleiterschaltmittel 5b beispielswiese bis ca. 10 pA auftreten. Hieraus ergibt sich beispielsweise ein vorgegebener Schwellenwert von 50 pA, da bei diesem Schwellenwert eine maximale Schaltfrequenz des Relais unter 5 Hz bleibt. Typische Schwellenwerte liegen beispielsweise zwischen 20 pA und 200 pA.

Fig. 3 zeigt schematisch ein detaillierteres Schaltbild der Steuereinheit 5c des Strom/Frequenz-Wandlers 2. Wie dargestellt, weist die Steuereinheit 5c Gatter 5ca, 5cb, 5cc und 5cd zur Erzeugung der Steuersignale "relay" und "switch" in Abhängigkeit von dem Messsignal comp auf.

Die Funktion der Steuereinheit 5c ist wie folgt. Das Relais 5a wird für eine vorgegebene Zeit tr nach einer positiven Flanke des Messsignals comp geschlossen. Die vorgegebene Zeit tr kann beispielsweise 200 ms betragen. Bei mehreren aufeinanderfolgenden Pulsen kann das Relais 5a dauerhaft geschlossen bleiben, wenn die vorgegebene Zeit tr größer als die Zeitdauer zwischen den Pulsen ist. Das Halbleiterschaltmittel 5b wird für eine vorgegebene Zeit ts, beispielsweise 20 µs, nach der Flanke des Messsignals comp geschlossen. Weiter wird das Halbleiterschaltmittel 5b für eine vorgegebene Zeit trs, beispielsweise 2 ms, nach jedem Schließen des Relais 5a geschlossen, da Relais grundsätzlich träge sind. Dies wird durch das Gatter 5cb bewirkt. Es wird also sichergestellt, dass ein "switch"-Puls erzeugt wird, der länger ist als das Relais benötigt, um vollständig zu schließen, wodurch ein zuverlässiges Entladen des Integrationskondensators 3a sichergestellt wird. Die Zeitdauer tr wird grundsätzlich größer als die Zeitdauer ts gewählt.

## Patentansprüche

1. Messgerät (100) zum Ermitteln einer Messgröße, aufweisend:
- einen Sensor (1) zur Erzeugung eines von der Messgröße abhängigen Messstroms (i),
- einen Strom/Frequenz-Wandler (2), der dazu ausgebildet ist, ein, insbesondere rechteckförmiges, Messsignal (comp) zu erzeugen, dessen Frequenz von der Stromstärke des Messstroms (i) abhängt, wobei der Strom/Frequenz-Wandler (2) aufweist:
- einen Integrationskondensator (3a), der während eines Ladezyklus mit dem Messstrom (i) geladen wird, und
- eine Entladeschaltung (5), die dazu ausgebildet ist, den Integrationskondensator (3a) während eines Entladezyklus zu entladen, sobald ein Betrag einer an dem Integrationskondensator (3a) auftretenden Spannung einen vorgegebenen Schwellenwert (Vth) überschreitet,
- wobei die Frequenz des Messsignals (comp) der Frequenz entspricht, mit der sich Ladezyklen und Entladezyklen abwechseln, und
- eine Auswerteeinheit (4), die dazu ausgebildet ist, basierend auf der Frequenz des Messsignals (comp) die Messgröße zu ermitteln,
**dadurch gekennzeichnet, dass**
- die Entladeschaltung (5) aufweist:
- ein Relais (5a),
- ein Halbleiterschaltmittel (5b),
- wobei das Relais (5a) und das Halbleiterschaltmittel (5b) in Reihe geschaltet sind und die Reihenschaltung aus Relais (5a) und Halbleiterschaltmittel (5b) dem Integrationskondensator (3a) parallel geschaltet ist, und
- eine Steuereinrichtung (5c), die dazu ausgebildet ist, das Relais (5a) und das Halbleiterschaltmittel (5b) in Abhängigkeit von der Stromstärke des Messstroms (i) anzusteuern.

2. Messgerät (100) nach Anspruch 1, **dadurch gekennzeichnet, dass**
- die Steuereinrichtung (5c) dazu ausgebildet ist,
- falls ein Betrag einer Stromstärke des Messstroms (i) einen vorgegebenen Schwellenwert unterschreitet, während des Ladezyklus das Relais (5a) derart anzusteuern, dass das Relais (5a) geöffnet ist, und
- falls der Betrag der Stromstärke des Messstroms (i) den vorgegebenen Schwellenwert überschreitet, während des Ladezyklus das Relais (5a) derart anzusteuern, dass das Relais (5a) geschlossen ist.

3. Messgerät (100) nach einem der vorhergehenden Ansprüche, **dadurch gekennzeichnet, dass**
- die Steuereinrichtung (5c) dazu ausgebildet ist, während des Entladezyklus das Relais (5a) und das Halbleiterschaltmittel (5b) für eine Mindestzeitdauer gleichzeitig zu schlie-ßen.

4. Messgerät (100) nach einem der vorhergehenden Ansprüche, **dadurch gekennzeichnet, dass**
- das Relais (5a) ein Reed-Relais ist.

5. Messgerät (100) nach einem der vorhergehenden Ansprüche, **dadurch gekennzeichnet, dass**
- der Sensor (1) ein Photomultiplier ist.

6. Messgerät (100) nach einem der Ansprüche 1 bis 4, **dadurch gekennzeichnet, dass**
- der Sensor (1) ein Zählrohr ist.

7. Messgerät (100) nach einem der Ansprüche 1 bis 4, **dadurch gekennzeichnet, dass**
- der Sensor (1) eine Ionisationskammer ist.

8. Messgerät (100) nach einem der vorhergehenden Ansprüche, **dadurch gekennzeichnet, dass**
- der Strom/Frequenz-Wandler (2) einen Operationsverstärker (3b) aufweist, wobei der Integrationskondensator (3a) und der Operationsverstärker (3b) derart verschaltet sind, dass diese einen Integrierer (3) zum Integrieren des Messstroms (i) bilden.

9. Messgerät (100) nach einem der vorhergehenden Ansprüche, **dadurch gekennzeichnet, dass**
- die Messgröße eine Eigenschaft ionisierender Strahlung ist.

## Claims

1. Measuring device (100) for determining a measurement variable, comprising:
- a sensor (1) for generating a measurement current (i) which is dependent on the measurement variable,
- a current/frequency converter (2) which is designed to generate an, in particular square-wave, measurement signal (comp), the frequency of which depends on the current intensity of the measurement current (i), wherein the current/frequency converter (2) comprises:
- an integration capacitor (3a) which is charged using the measurement current (i) during a charging cycle, and
- a discharge circuit (5) which is designed to discharge the integration capacitor (3a) during a discharge cycle as soon as a magnitude of a voltage occurring at the integration capacitor (3a) exceeds a predefined threshold value (Vth),
- wherein the frequency of the measurement signal (comp) corresponds to the frequency at which charging cycles and discharge cycles alternate, and
- an evaluation unit (4) which is designed to determine the measurement variable based on the frequency of the measurement signal (comp),
**characterized in that**
- the discharge circuit (5) comprises:
- a relay (5a),
- a semiconductor switching means (5b),
- wherein the relay (5a) and the semiconductor switching means (5b) are connected in series and the series circuit composed of the relay (5a) and the semiconductor switching means (5b) is connected in parallel with the integration capacitor (3a), and
- a control device (5c) which is designed to actuate the relay (5a) and the semiconductor switching means (5b) depending on the current intensity of the measurement current (i).

2. Measuring device (100) according to Claim 1, **characterized in that**
- the control device (5c) is designed,
- if a magnitude of a current intensity of the measurement current (i) falls below a predefined threshold value, to actuate the relay (5a) during the charging cycle in such a way that the relay (5a) is open, and
- if the magnitude of the current intensity of the measurement current (i) exceeds the predefined threshold value, to actuate the relay (5a) during the charging cycle in such a way that the relay (5a) is closed.

3. Measuring device (100) according to either one of the preceding claims, **characterized in that**
- the control device (5c) is designed to close the relay (5a) and the semiconductor switching means (5b) simultaneously for a minimum period during the discharge cycle.

4. Measuring device (100) according to either one of the preceding claims, **characterized in that**
- the relay (5a) is a Reed relay.

5. Measuring device (100) according to either one of the preceding claims, **characterized in that**
- the sensor (1) is a photomultiplier.

6. Measuring device (100) according to any one of Claims 1 to 4, **characterized in that**
- the sensor (1) is a counting tube.

7. Measuring device (100) according to any one of Claims 1 to 4, **characterized in that**
- the sensor (1) is an ionization chamber.

8. Measuring device (100) according to either one of the preceding claims, **characterized in that**
- the current/frequency converter (2) comprises an operational amplifier (3b), wherein the integration capacitor (3a) and the operational amplifier (3b) are interconnected in such a way that they form an integrator (3) for integrating the measurement current (i).

9. Measuring device (100) according to either one of the preceding claims, **characterized in that**
- the measurement variable is a property of ionizing radiation.

## Revendications

1. Appareil de mesure (100) pour déterminer une grandeur de mesure, possédant :
- un capteur (1) destiné à générer un courant de mesure (i) dépendant de la grandeur de mesure,
- un convertisseur courant/fréquence (2), qui est configuré pour générer un signal de mesure (comp), notamment rectangulaire, dont la fréquence dépend de l'intensité du courant de mesure (i), le convertisseur courant/fréquence (2) possédant :
- un condensateur d'intégration (3a), qui est chargé par le courant de mesure (i) pendant un cycle de charge, et
- un circuit de décharge (5), qui est configuré pour décharger le condensateur d'intégration (3a) pendant un cycle de décharge dès qu'un montant d'une tension qui se produit au niveau du condensateur d'intégration (3a) dépasse une valeur de seuil (Vth) prédéfinie,
- la fréquence du signal de mesure (comp) correspondant à la fréquence à laquelle les cycles de charge et les cycles de décharge alternent, et
- une unité d'évaluation (4), qui est configurée pour déterminer la grandeur de mesure sur la base de la fréquence du signal de mesure (comp),
**caractérisée en ce que**
- le circuit de décharge (5) possède :
- un relais (5a),
- un moyen de commutation semiconducteur (5b),
- le relais (5a) et le moyen de commutation semiconducteur (5b) étant branchés en série, et le circuit série composé du relais (5a) et du moyen de commutation semiconducteur (5b) étant branché en parallèle avec le condensateur d'intégration (3a), et
- un dispositif de commande (5c), qui est configuré pour commander le relais (5a) et le moyen de commutation semiconducteur (5b) en fonction de l'intensité du courant de mesure (i).

2. Appareil de mesure (100) selon la revendication 1, **caractérisé en ce que**
- le dispositif de commande (5c) est configuré pour,
- dans le cas où un montant d'une intensité du courant de mesure (i) devient inférieur à une valeur de seuil prédéfinie, commander le relais (5a) pendant le cycle de charge de telle sorte que le relais (5a) soit ouvert, et
- dans le cas où le montant de l'intensité du courant de mesure (i) devient supérieur à la valeur de seuil prédéfinie, commander le relais (5a) pendant le cycle de charge de telle sorte que le relais (5a) soit fermé.

3. Appareil de mesure (100) selon l'une des revendications précédentes, **caractérisé en ce que**
- le dispositif de commande (5c) est configuré pour fermer simultanément le relais (5a) et le moyen de commutation semiconducteur (5b) pendant une durée minimale pendant le cycle de décharge.

4. Appareil de mesure (100) selon l'une des revendications précédentes, **caractérisé en ce que**
- le relais (5a) est un relais Reed.

5. Appareil de mesure (100) selon l'une des revendications précédentes, **caractérisé en ce que**
- le capteur (1) est un photomultiplicateur.

6. Appareil de mesure (100) selon l'une des revendications 1 à 4, **caractérisée en ce que**
- le capteur (1) est un tube de comptage.

7. Appareil de mesure (100) selon l'une des revendications 1 à 4, **caractérisée en ce que**
- le capteur (1) est une chambre d'ionisation.

8. Appareil de mesure (100) selon l'une des revendications précédentes, **caractérisé en ce que**
- le convertisseur courant/fréquence (2) possède un amplificateur opérationnel (3b), le condensateur d'intégration (3a) et l'amplificateur opérationnel (3b) étant connectés de telle sorte que ceux-ci forment un intégrateur (3) destiné à intégrer le courant de mesure (i) .

9. Appareil de mesure (100) selon l'une des revendications précédentes, **caractérisé en ce que**
- la grandeur mesurée est une propriété du rayonnement ionisant.
